(19) **Europäisches Patentamt**
**European Patent Office**
**Office européen des brevets**

(11) **EP 3 586 377 B1**

(12) **EUROPEAN PATENT SPECIFICATION**

(45) Date of publication and mention
of the grant of the patent:
**28.07.2021  Bulletin 2021/30**

(51) Int Cl.:
*H01L 31/048* [(2014.01)]     *H01L 31/055* [(2014.01)]
*H01L 31/054* [(2014.01)]

(21) Application number: **18710922.8**

(86) International application number:
**PCT/IT2018/050023**

(22) Date of filing: **20.02.2018**

(87) International publication number:
**WO 2018/154616 (30.08.2018 Gazette 2018/35)**

(54) **DEVICE AND REALIZATION METHOD OF LUMINESCENT SOLAR CONCENTRATORS BASED ON SILICON NANOSTRUCTURES**

VORRICHTUNG UND VERFAHREN ZUR HERSTELLUNG VON LUMINESZENTEN SOLARKONZENTRATOREN AUF BASIS VON SILICIUMNANOSTRUKTUREN

DISPOSITIF ET PROCÉDÉ DE RÉALISATION DE CONCENTRATEURS SOLAIRES LUMINESCENTS À BASE DE NANOSTRUCTURES DE SILICIUM

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **21.02.2017  IT 201700018941**

(43) Date of publication of application:
**01.01.2020  Bulletin 2020/01**

(73) Proprietors:
- **Alma Mater Studiorum - Universita' Di Bologna**
  **40126 Bologna (IT)**
- **Consiglio Nazionale Delle Ricerche**
  **00185 Roma (IT)**

(72) Inventors:
- **CERONI, Paola**
  **40126 Bologna (IT)**

- **MAZZARO, Raffaello**
  **40132 Bologna (BO) (IT)**
- **BERGAMINI, Giacomo**
  **40126 Bologna (IT)**
- **ARRIGO, Antonino**
  **40141 Bologna (BO) (IT)**
- **ROMANO, Francesco**
  **36100 Vicenza (VI) (IT)**
- **MORANDI, Vittorio**
  **00185 Roma (IT)**
- **CANINO, Mariaconcetta**
  **00185 Roma (IT)**

(74) Representative: **Tiburzi, Andrea et al**
**Barzanò & Zanardo Roma S.p.A.**
**Via Piemonte 26**
**00187 Roma (IT)**

(56) References cited:
**US-A1- 2010 180 932     US-A1- 2013 037 514**

**Description**

The present invention relates to a device and realization method of luminescent solar concentrators based on silicon nanostructures.

More specifically, the invention concerns a device of the above type, designed and manufactured in particular to convert solar energy into electrical energy in a transparent material, which can be used in architectural elements, such as windows and the like.

In the following the description will be directed to the use of said device in particular for windows, but it is clear that it should not be considered limited to this specific use.

As is well known, the search for cheap, abundant and renewable energy sources is one of the current most ambitious technological objectives. The document US2010/180932A describes energy conversion devices.

Currently, the 85% of the total energy consumed on earth comes from fossil fuels, with the well-known consequences to global warming and to the human health.

Furthermore, the supply of fossil fuels is becoming increasingly expensive and difficult, as natural resources are progressively decreasing. In fact, it is expected that in 50-100 years these resources will by then be exhausted.

The search for alternative energy sources has therefore become a necessity.

Sunlight is the most economical, most evenly distributed, abundant and renewable energy source on the earth. The power of solar radiation that hits the surface of our planet is 10.000 times higher than the current global energy demand. In order to be usable, however, solar energy must be converted into forms that can be directly usable.

Although the systems based on solar cells (or Solar Cells) at low cost and high performance are currently very reliable, commercially available and widely developed, further advances in science and technology of solar cells need so as the photovoltaic to become the major source of energy and electricity in the world, so as to contribute to a significant extent to the generation of renewable electricity by 2020 (Horizon 2020).

One of the possibilities for converting solar energy into electricity currently studied is linked to the use of luminescent solar concentrators.

These devices are based on a polymeric or glass plate, inside (or on the surface) of which luminescent species are included capable of absorbing the incident light and re-emitting it at a specific wavelength within the solid matrix.

The incident light is then directed to the edges of the sheet, using internal total reflection processes. Placing in contact said edges of conventional solar cells having a good spectral overlap with the emitter included in the matrix, said light can be converted into electrical energy.

This device allows concentrating the light absorbed over a large area by a relatively low-cost material, on a series of small area photovoltaic cells.

This means, therefore, that high efficiency cells can be used, given the relative low cost of small dimension cells, keeping good overall efficiency levels and reduced costs.

Furthermore, this approach allows creating semi-transparent devices of remarkable interest for the integration of photovoltaic devices into architectural elements, such as windows or facades.

In this context, many emitters have been up to now used, starting from the common organic fluorophores to emitting nanomaterials.

The main limits of the emitters proposed up to now consist of:

- a high light reabsorption, which limits considerably the efficiency of the concentrator;
- a high degree of absorption in the visible spectrum, which limits its use as a transparent device;
- a low stability in case of organic fluorophores;
- a high intrinsic toxicity in case of lead and cadmium emitters;
- a high synthesis complexity in case of multi-layer nanomaterials.

Solar energy conversion devices according to the prior art are also described in the international patent application WO2015/002995A1, in the article Meinardi, F.; McDaniel, H.; Carulli, F.; Colombo, A.; Velizhanin, K. A.; Makarov, N. S.; Simonutti, R.; Klimov, V. I.; Brovelli, S. Nat. Nanotechnol. 2015, 10 (10), 878-885, in the international patent application WO2016/060643A and in the international patent application WO2016/028855A.

In particular, the international patent application WO2016/060643 concerns a solar energy conversion device that uses different kinds of core-shell nanocrystals. For the operation of the device it is necessary, in particular, the presence of a core and a shell, both involved in the process of light absorption and emission.

The patent application WO2016/028855A1, moreover, concerns the functionalization of silicon nanocrystals with chromophoric ligands such as optical probes, which however increase the absorption properties of the material in the visible, an effect not required and even dangerous for the applications.

Consider, in particular, that it is known the application of quantum dots in polymeric matrices to which a solar cell is coupled. The advantage of this technology is to show a bandwidth (or "band-gap") easily adjustable according to the size of said quantum dots. Recently, however, despite the good results in terms of efficiency, it was found that quantum dots present toxicity problems.

It is apparent that the solutions according to the prior art are not optimal in terms of technical performance and efficiency, and therefore still not usable for commercial purposes.

In light of the above, it is therefore an object of the present invention overcoming the technical limits of the currently known solar energy conversion devices.

It is also an object of the present invention to propose a solar energy conversion device made of non-toxic, non-rare, and highly transparent materials.

It is a further object of the present invention to propose a method for producing said solar energy conversion device.

It is specific object of the present invention an energy conversion device, particularly electromagnetic energy, such as sunlight and the like, is as recited in claim 1.

Still according to the invention, said silicon nanostructures may have a size smaller than, or equal to 100 nm.

Advantageously according to the invention, the organic binders may be selected from the group consisting of: linear alkyl or alkenyl binders, such as 1-dodecene, 1-decene, 1-hexadecene, 1-undecene, 1-octadecene; alkyl or alkenyl silicon-containing binders, such as chloro(dimethyl) vinylsilane, chloro(dimethyl) allylxylane, chloro(dipropyl) vinylsilane, chloro(dibenzyl) vinylsilane and derivatives of the same; ethylene glycols binders; aromatic binders, such as styrene, phenylacetylene, anthracene, naphthalene, 2-aminopyridine, quinine sulphate and derivatives of the same; said binder providing specific solubility, dispersion, stability or ultraviolet light absorption properties, said binders mixtures can be used to provide simultaneously different properties.

Preferably according to the invention, the ratio between the functional monomer and the linking agent described above may be comprised between 5% and 30%.

It is further object of the present invention a method for realizing a polymeric matrix, for the manufacture of a transparent polymer sheet, as recited in claim 5.

Always according to the invention, said functionalizing step (c) may comprise the step of induced passivation by heating the silicon nanostructures in an inert atmosphere at temperatures greater than, or equal to 150 °C, with an organic binder.

Still according to the invention, said functionalizing step (c) may comprise the passivation step induced by the activation of the silicon nanostructure by reaction with a diazonium salt, such as for example, 4-decylbenzene diazonium tetrafluoroborate, 4-bromobenzene diazonium tetrafluoroborate, 2-nitro-4-decyl-benzene diazonium tetrafluoroborate and 2,6-bromo-decyl-benzene diazonium tetrafluoroborate or AIBN (2,2'-azobis (2-methylpropionitrile) and subsequent addition of the organic binder in solvents such as toluene, hexane, cyclohexane, dichloromethane, chloroform, tetrahydrofuran.

Advantageoulsy according to the invention, in the passivation step it may be used a solvent selected from the same organic ligand or a neutral solvent selected from dodecane, hexadecane, octadecane, mesitylene, dichlorobenzene, trichlorobenzene, toluene, hexane, cyclohexane, dichloromethane, chloroform, tetrahydrofuran.

Preferably according to the invention, said in-situ polymerization step (d) may be carried out by dispersing said silicon nanostructures in a mixture of functional monomer and linking agent with a thermal or photochemical initiator.

Always according to the invention, said mixture of lauryl methacrylate/ethylene glycol dimethacrylate comprises lauryl methacrylate from 60% to 90% by weight and ethylene glycol dimethacrylate from 10 to 40% by weight.

Still according to the invention, said thermal initiator may be a solution of lauryl peroxide, AIBN (2,2'-azobis (2-methylpropionitrile, ABCN 1,1'-azobis (cyclohexanecarbonitrile) or benzoyl peroxide, in a concentration ranging from 0,05% to 1% by weight with respect to the solution.

Advantageously according to the invention, said photochemical initiator may be a solution of diphenyl (2, 4, 6-trimethylbenzoyl) phosphine oxide or Irgacure 651 in a concentration ranging from 0,05% to 1% by weight with respect to the solution.

Further according to the invention, said method mey comprise a thermal activation phase, at a temperature between 40 °C and 100 °C, and/or photochemistry activation phase, with irradiation in the range between 300 and 450 nm, of said polymerization of said mixture in an appropriate mold until reaching the solid state.

Preferably according to the invention, said method may comprise the step of removing the device from the mold and the following polishing of the surface by mechanical means.

Always according to the invention, said nanostructures may comprise silicon nanocrystals and/or nanowires of silicon and/or porous silicon.

The present invention will be now described, for illustrative but not limitative purposes, according to its preferred embodiments, with particular reference to the figures of the enclosed drawings, wherein:

figure 1 shows a schematic view of the operating principle of a solar energy conversion device according to the present invention;

figure 2 shows the scheme of the polymerization process that leads to the transparent polymeric material with different percentages of silicon nanostructures (increasing percentage from left to right);

figure 3 shows a graph showing the photophysical properties of two experimental samples in a solution of toluene of a polymeric matrix made according to the present invention;

figure 4a shows the transmittance of visible and UV light of the four samples shown in figure 2;

figure 4b shows the chromaticity diagram of the four samples shown in figure 2;

figure 5 shows normalized emission spectra of silicon nanocrystals SiNCs of different sizes (3 nm and 5 nm) in solution and in polymeric matrix;

figure 6 shows the external quantum efficiency (EQE) for some nanocrystals in solution or included in a polymeric matrix possibly with or without the masked edges;

figure 7 shows emission spectra of a polymeric matrix with silicon nanocrystals detected at the greater distance between the excitation source and the emission point;

figure 8 shows the dependency of the efficiency of a photovoltaic cell and the optical efficiency with respect to the G factor; and

figure 9 shows the comparison between the spectral response of a photovoltaic cell illuminated perpendicular to the surface and that obtained for the photovoltaic cell coupled with polymeric plates with different concentrations of nanocrystals, or without nanocrystals.

In the various figures, similar parts will be indicated by the same reference numbers.

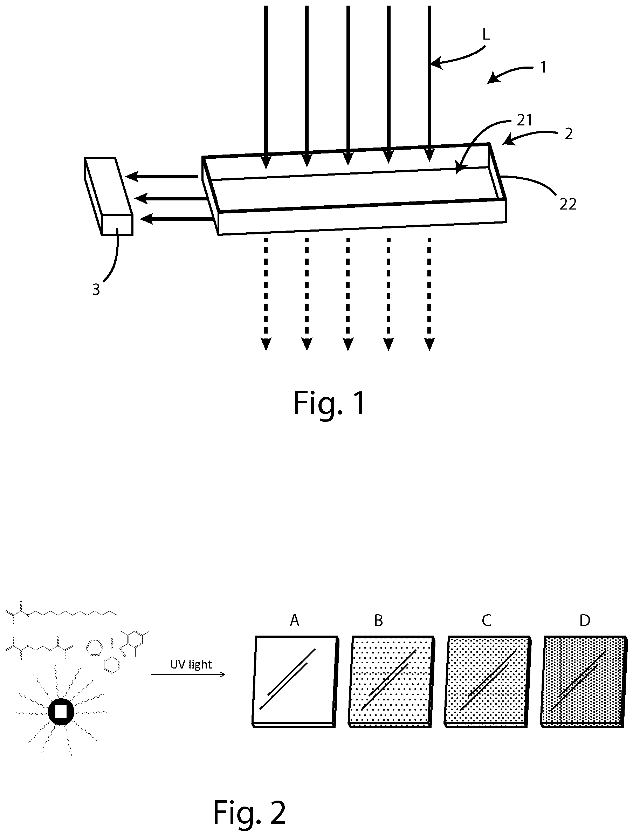

Referring to figure 1, a schematic functional view of a solar energy conversion device 1 according to the present invention is observed.

The device 1 comprises a transparent polymeric sheet 2 and at least one solar cell 3, placed on at least oneportion of the edge 22 of the polymer sheet 2 and mechanically coupled to it, e.g. by a layer of transparent adhesive tape, in order to reduce the roughness of the polymer sheet 2 and to increase the optical quality.

Said polymer sheet 2 comprises nanostructures, in particular silicon nanocrystals SiNCs, functionalized with alkyl derivatives, which are luminescent in red or in the near infrared (NIR).

The nanostructures contained in the polymer sheet 2 are included by in-situ polymerization (see also figure 2), thermally or photochemically carried out by a UV source.

These nanostructures are generally silicon nanocrystals (also SiNcs), but they can also be silicon nanotubes, silicon nanowires or porous silicon. In the following, in any case, reference will be made to the use of SiNcs silicon nanocrystals, without this being a limitation of the scope of protection.

It is seen that the solar energy conversion device 1 shows a high simplicity of the encapsulation process of the nanomaterial in the matrix and compatibility with the polymerization process, as better defined below.

Silicon nanocrystals (SiNCs) have particular optical and electronic properties, as better discussed below, compared to those of massive silicon. These properties are mainly connected to quantum confinement effects and are therefore strongly dependent on the size, shape, surface functionalization of the nanocrystals and the presence of defects.

In general, silicon nanocrystals preferably have a size between 2-12 nm, thus showing a light emission that can be regulated form the visible spectrum region to the near infrared spectrum region, simply by increasing their size.

Moreover, silicon nanocrystals have different advantages with respect to known, more widespread and used quantum dots, which, as mentioned, generally contain rare and/or toxic materials such as lead, cadmium, indium, selenium.

Figure 2 shows a synthesis of the diagram of the polymerization process for obtaining the transparent polymeric material with different percentages of silicon nanostructures (increasing percentage from left to right of the above figure, indicating the samples obtained with A (no nanostructure), B, C and D, which indicate different concentrations and dimensions of silicon nanocrystals SiNCs, as better explained below).

Among the advantages of silicon nanocrystals SiNCs, the following can be mentioned.

Preliminarily, silicon is abundant, readily available and essentially non-toxic. Furthermore, silicon can form covalent bonds with carbon, thus providing the possibility of integrating inorganic and organic components into a robust structure.

Moreover, as the size of silicon nanocrystals SiNCs varies, it is possible to control the absorption and the emission spectra, which can therefore cover the entire ultraviolet, visible and near infrared spectrum.

In the energy conversion device 1 according to the present invention, the silicon nanocrystals SiNCs are obtained as follows:

(a) they are synthesized by annealing (heat treatment) in a reducing atmosphere of polysiloxanes (inorganic polymers based on a silicon-oxygen chain and organic functional groups linked to silicon atoms);

(b) the powder obtained in the previous step is treated with hydrofluoric acid, to remove the silicon oxide matrix and release the hydride terminated silicon nanostructures;

(c) the nanocrystals are then functionalized with alkenyl derivatives, to obtain optimal optical properties for the application described (emission in the desired spectral region, quantum yield between 30 and 60%, lack of reabsorption) and guarantee the correct solubilization and stabilization of the nanocrystals inside of the polymer matrix.

The above functionalization step (c) can be obtained according to one of the following two methods:

- passivation induced by heating the nanocrystal in an inert atmosphere at temperatures higher than 150 °C in the presence of alkenyl binder, in order to obtain the relative functionalization. One or more binders can be used, depending on the properties to be supplied to the nanocrystal, such as maintenance or optimization of the optical properties described above, stabilization with respect to aggregation, prevention of energy transfer between different crystals, chemical stability against oxidative processes. The functionalization can be carried out using the binder as solvent or in the presence of neutral and high-boiling solvent (dodecane, hexadecane, octadecane, mesitylene, dichlorobenzene, trichlorobenzene);
- passivation induced by activation, by means of diazonium salt. In this case the passivation can take place at room temperature by the addition of a special diazonium salt (for example 4-decylbenzene diazonium tetrafluoroborate) and by the following addition of alkenyl binder. In this case, the presence of a high-boiling solvent (toluene, hexane, cyclohexane) is not necessary.

Such binders will have the role of providing specific solubility, dispersion, stability or ultraviolet light absorption properties. Mixtures of binders can be used to provide different properties at the same time.
As said, the obtained nanocrystals are included within a polymer or polymer matrix by in situ polymerization of a mixture of lauryl methacrylate/ethylene glycol dimethacrylate comprises lauryl methacrylate, 80% by weight of the mixture, and ethylene glycol dimethacrylate, 20% by weight of the mixture, in the presence of a thermal initiator (lauroyl peroxide 0,05-0,1% by weight with respect to the solution) or photochemical (diphenyl) (2, 4, 6-trimethylbenzoyl) phosphinide 0,05-0,1% by weight with respect to the solution).
Said nanocrystals maintain their luminescence properties within the polymeric matrix due to the protective function provided by the organic binder covalently bonded to the silicon core.
As anticipated, a new aspect of the solar energy conversion device 1 according to the invention concerns the use of silicon nanostructures functionalized with organic binders.
These offer optimal optical properties for the indicated applications, allowing:

- an emission in a variable range of the light spectrum as the dimensions vary;
- a high luminescent quantum performance; and
- an absorption spectrum mainly positioned in the near UV region and high Stokes-shift (distance in energy between maximum absorption and light emission) that prevents effects of reabsorption of the emitted light, generally due to a remarkable decrease in the efficiency of this type of device.

Unlike other types of nanocrystals, silicon nanocrystals SiNCs have the advantage of being made of a single element, contrary, for example, to mixed semiconductors based on PbS, CdS, CdSe, CdTe, CuInSe etc..
The organic functionalization also allows modifying the optical, solubility, dispersion and stability properties.
In general, the optical performance of the polymer sheet 2, which actually acts as, and it is a luminescent solar concentrator (also Luminescent Solar Concentrator - LSC) is defined as the fraction of the incident photons L on said polymer sheet 2, which are re-emitted and capable of reaching the edges 22 and therefore the solar cell 3. The optical efficiency of said polymer sheet 2 is influenced by several factors, shown in the following equation:

$$\eta_{opt} = (1-R)PTIR\eta_{abs}\eta_{PL}\eta_{Stokes}\eta_{wvg}\eta_{self}$$

wherein R is the reflection of the light incident on the polymer surface, which said polymer sheet 2 is constituted of, PTIR is the total internal reflection efficiency defined by Snell's law, $\eta_{abs}$ is the fraction of light absorbed by the photoactive elements, $\eta_{PL}$ is the photoluminescent quantum yield, $\eta_{Stokes}$ is the energy lost due to the generation of heat from absorption-emission events, $\eta_{wvg}$ is the transport efficiency of the photons emitted through the waveguide relative to the geometry and the smoothness of the surface of said polymer sheet 2, $\eta_{self}$ is the transport efficiency due to reabsorption.
The two main contributions, in terms of loss probability, are the superficial losses described by R and $\eta_{wvg}$, and the reabsorption.
While the first problem can be addressed by the use of different configurations, such as the use of a cylindrical or semi-reflecting layers, the second is mainly related to the photophysics of the lumonophore (i.e., in the case at issue, of the silicon nanocrystal SiNCs).

The use of nanomaterials designed to achieve a Stokes-shift effect, such as silicon nanocrystals SiNCs, reduces considerably the losses due to re-absorption. In fact, silicon is an indirect band-gap semiconductor and, despite the photoluminescence quantum yield up to 45%, when the size is reduced at the level of nanostructures, it is characterized by a long duration of photoluminescence and high Stokes-shift, which is typical of transitions assisted by phonons.

The preparation of a test solar energy conversion device 1 according to the invention is described in detail below.

Two batches of silicon nanocrystals SiNCs passivated in dodecene are synthesized respectively preparing nanocrystals with an average diameter of about ~ 3 nm and ~ 5 nm.

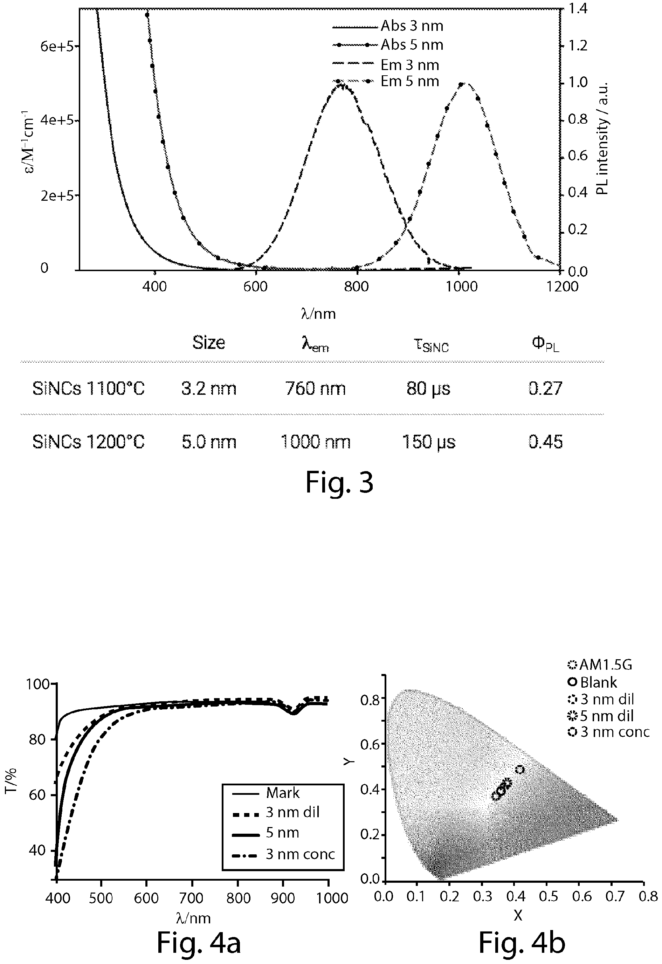

The main photophysical properties of the samples in toluene solution are shown in figure 3. It can be seen that, by increasing the size of silicon nanocrystals SiNCs, the wavelength corresponding to the maximum photoluminescence intensity (Photoluminescence - PL) is shifted in order to lower the energy towards the near infrared NIR region (following a smaller band gap for larger nanocrystals).

As already highlighted, the photoluminescence in the microsecond interval confirms the nature of indirect band-gap of the material. Even the apparent Stokes-shift, corresponding to the energy gap between the end of the absorption tail and the beginning of the emission band, increases with the size of the silicon core.

The polymer test plates in which the silicon nanocrystals SiNCs are incorporated have been prepared by adapting a process described in the article of Coropceanu, I.; Bawendi, M.G. Nano Lett. 2014, 14 (7), 4097-4101, reducing the quantity of photoinitiator, in order to optimize the light component absorbed by silicon nanocrystals SiNCs: 300 ml of concentrated silicon nanocrystal SiNCs solution in toluene (~ 10-4-10-3M depending on the batch) were carefully dried under vacuum.

Meanwhile, a solution of the monomeric precursor (LMA, lauroyl methacrylate, Sigma-Aldrich), cross-linking agent (EGDM, ethylene glycol dimethacrylate, Sigma-Aldrich, 20% w/w with respect to LMA) and a UV initiator (diphenyl (2), 4, 6-trimethylbenzoyl) phosphinide oxide), Sigma-Aldrich, 0,1%) was prepared by sonication for 10 minutes.

The silicon nanocrystals SiNCs were then dissolved in 6 ml of monomer and the solution was degassed in 3 cycles of freezing-pumping-thawing, to prevent the formation of bubbles during polymerization. The solution was then placed in a mold consisting of two sheets of glass, separated by a silicone spacer and irradiated with a radiation having a wavelength $\lambda_{exc}$ = 365 nm for 1 hour.

The resulting polymer plate was left in the dark for 24 hours, to allow the completion of the polymerization. Then the mold was removed and the obtained polymer matrix was polished with abrasive paper and diamond paste (1 micron), in such a way as to limit the roughness of the surface of the device, improving the waveguide effect.

The photophysical characterizations of the test polymer matrix obtained above intended for the manufacture of the polymer sheet 2 of the conversion device 1 are examined below.

In particular, three examples of polymer matrix were prepared with silicon nanocrystals SiNCs with an average size of about 30x25x4 mm (refer again to figure 2), incorporating silicon nanocrystals SiNCs having the dimension of 3 nm at different concentrations (respectively $4x10^{-6}$ M for the sample B sample and $2x10^{-5}$ M for the sample D) or silicon nanocrystals SiNCs of 5 nm (sample C). A reference sample was also prepared without inserting any luminophore.

The sample transmission spectra are shown in figure 4a. Comparing the spectra in the low-energy region, no evidence of aggregation is observed and the average transmittance (800-600 nm) is higher than 94%, demonstrating the excellent degree of transparency of the prepared polymeric sheets or matrices.

The unstructured band at wavelengths lower than 500 nm is related to the absorption of silicon nanocrystals SiNCs.

The average transmittance was calculated in the visible region (400-800 nm) and the extracted values, shown in the table below, ranged from 92% of the blank sample, to 83% of the sample with silicon nanocrystals SiNCs of concentrated 3 nm size. This means that, in the worst case, silicon nanocrystals SiNCs absorb less than 10% of the incident light, so a high degree of transparency is maintained.

Since the average transmittance provides only limited information about the visual appearance of the semi-transparent plate, the color coordinates and the color rendering (CRI) have been calculated using the CIE 1931 chromaticity diagram, whose values are shown in the following table.

|   |          | Average transmittance % | x      | y      | Colour Rrendering Index |
|---|----------|-------------------------|--------|--------|-------------------------|
|   | AM 1,5 G | -                       | 0,3470 | 0,3694 | 95,70                   |
| A | Blank    | 92,1                    | 0,3602 | 0,3921 | 91,71                   |
| B | 3 nm dil | 89,3                    | 0,3724 | 0,4106 | 88,96                   |
| C | 5 nm dil | 87,3                    | 0,3817 | 0,4269 | 85,79                   |
| D | 3 nm conc| 83,4                    | 0,4016 | 0,4557 | 80,14                   |

It should be noted that the measure of AM 1.5 G is the standard solar irradiation (used to evaluate the efficiency of photovoltaic panels) through a thickness of 1,5 atmospheres, corresponding to solar irradiation with an angle at the zenith of 48,2°.

The color coordinates of the plates obtained are located in the central region of the chromaticity diagram shown in figure 4b, indicating good achromatic or neutral color perceptions. Only a small displacement to the yellow-orange region of the spectrum was detected for the concentrated sample with the silicon nanocrystal SiNCs at 3 nm.

Further indications about the color rendering have been provided by the calculation of the above mentioned CRI, whose value is between 91,71% for the blank sample, i.e. without silicon nanocrystals SiNCs, and 80,14% for the sample with the highest concentration of silicon nanocrystals SiNCs with crystal size of 3 nm. These values meet the CIE requirements for interior lighting.

The photoluminescence properties of silicon nanocrystals SiNCs embedded in the matrix were compared with those in the solution, starting from the form factor.

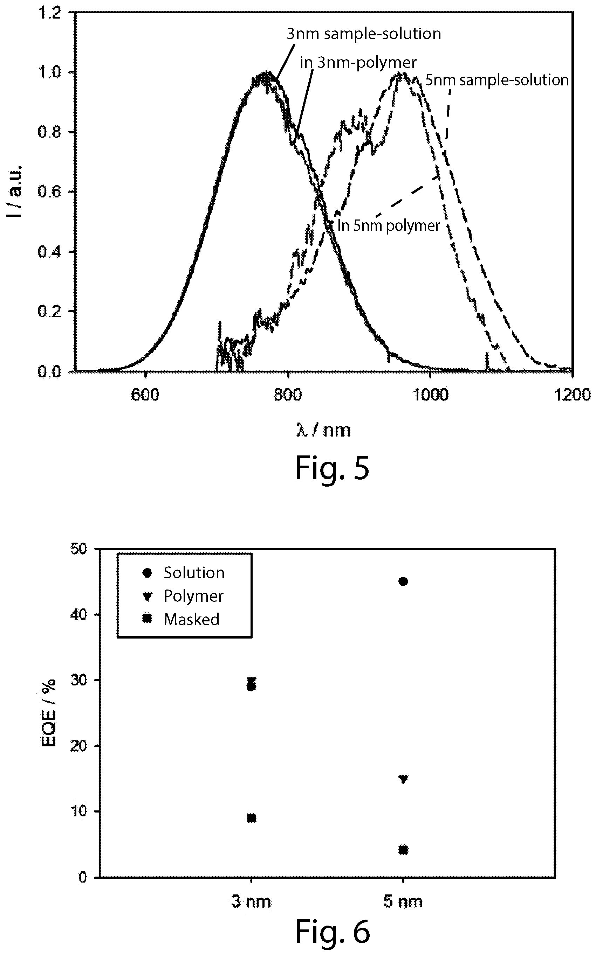

As is evident from figure 5, no particular variation of the band shape was observed for the sample having 3 nm silicon nanocrystals SiNCs, whereas the sample having 5 nm silicon nanocrystals SiNCs is characterized by a drastic change in the form of the band. This variation is due to the overlap of the emission band with the absorption bands of the polymer matrix.

The external quantum efficiency (also EQE) of silicon nanocrystals SiNCs, once incorporated into the polymer matrix, was evaluated and compared with the quantum photoluminescence yield of the same nanocrystals dissolved in toluene.

Firstly, the quantum yield measurement was performed on silicon nanocrystals SiNCs of 3 SiNCs nm and 5 nm in toluene solution.

For the evaluation of the EQE of silicon nanocrystals SiNCs embedded in the polymer matrix, a 3x2 cm support for the plates was constructed and a reference plate was prepared without the addition of silicon nanocrystals SiNCs. While, for the 3 nm silicon nanocrystals SiNCs sample , the EQE was observed to be relatively similar to that of the sample in solution, about 30%, the 5 nm silicon nanocrystals SiNCs sample is affected by a drastic decrease in the EQE up to 15%, due to the reabsorption of the polymer matrix.

In order to obtain information on the optical efficiency of the polymer sheet 2, the EQE of the silicon nanocrystals SiNCs embedded in the polymer sheet 2 itself was measured and compared with the EQE of the same polymer sheet 2 with edges masked (subtracting the contribution of the edges for the quantum efficiency). In particular, the edges of the sample were masked with 3 nm silicon nanocrystals SiNCs.

A decrease of the EQE from 30% to 9% has been observed (refer to the squares in figure 6), which indicates that 68% of the contribution to the overall emissions intensity comes from the edges of the polymer sheet 2, thus revealing that there are few losses due to reabsorption or reflection surface.

The same phenomenon was observed for the sample having silicon nanocrystals SiNCs of 5 nm, although the absolute values decrease from an EQE much lower than 15% to less than 4%.

This reduced efficiency is related to the lower quantum yield of the nanocrystals due to the polymer reabsorption.

This still implies a limitation on the use of luminophores emitting in the NIR (Near Infra-Red) region, i.e. 900-1100 nm, in the presence of a methacrylate matrix. Finally, to show the lack of re-absorption of the light emitted by silicon nanocrystals SiNCs, the luminescence was measured as a function of the distance between the excitation point and the radiation collection edge.

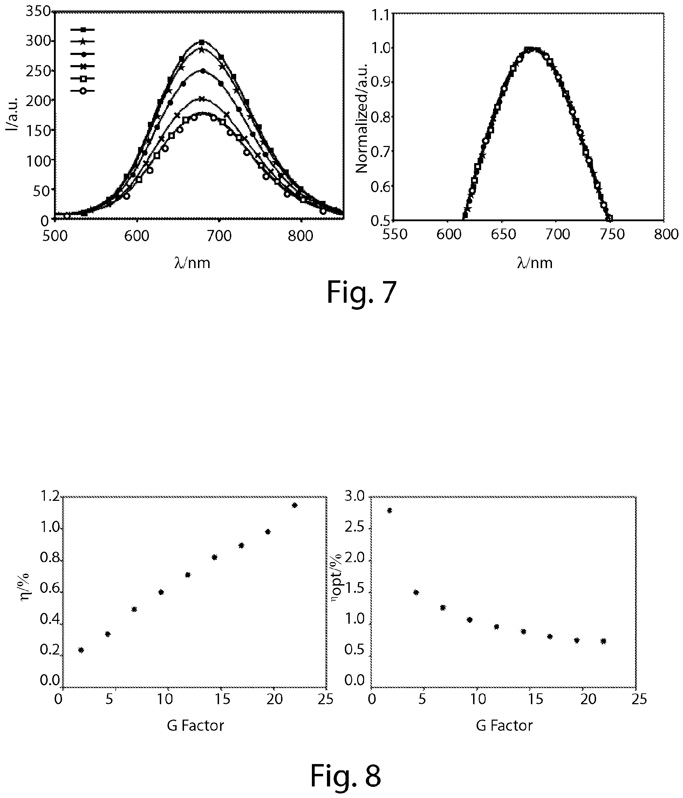

As shown in figure 7, the luminescence intensity decreases, as expected, due to optical losses and the geometric factor between the detector collecting angle and the emission cone, but no variation of the band shape was observed, indicating that there is no reabsorption.

The photovoltaic performance of the polymer sheet 2 according to the invention was evaluated by placing a photovoltaic cell 3 on the top of an edge of the plate, and measuring the efficiency of the cell radiating perpendicularly the plate surface with a conventional AM 1.5G solar simulator.

Measurements were made by leaving the edges 21 free from contact with any material, and by masking them with an aluminum sheet to make a mirror or by masking them with a specific black tape, capable of absorbing the light emitted from the edges in the whole visible and infrared spectrum.

The form factor, called G factor and defined as the ratio between the surface of the upper part of the polymer sheet 2 and the surface of the edges 21, has been calculated taking into consideration only the edge in contact with the photovoltaic cell 3 by placing mirrors on the other edges.

When no mirror was used during the measurement, the G factor was calculated considering the surface of all the edges 21 as active surface.

The optical contact between the photovoltaic cell 3 and the polymer sheet 2 has been optimized by adding a layer of transparent adhesive tape, in order to reduce the roughness of the face 22 of the polymer sheet 2 and to increase the optical quality of the interface with the solar cell 3.

Further polymer sheets 2 were prepared, having 3 nm silicon nanocrystals SiNs, changing the size of the plates themselves.

The size and composition of the samples is described in the following table, in analogy with the samples previously prepared for the physical photo characterization. The same table also shows the JV characteristics, i.e. the current-voltage density, together with the previously described G factor and the light fraction absorbed by the sample, calculated by integrating the absorption spectrum on the 1.5G AM spectrum.

| | Size / mm | G | □abs | Jsc / mA/cm2 | Voc / V | FF / % | PCE / % | □opt / % | □quantum / % |
|---|---|---|---|---|---|---|---|---|---|
| Blank | 23x22x3.9 | 1,00 1,00 (black) 5, 92 (mir) | - | 2,2 0,9 (black) 2,4 (mir) | 0,393 0,330 (black) 0,391 (mir) | 0,53 0,53 (black) 0,53 (mir) | 0,48 0,17 (black) 0,49 (mir) | 7,0% 3,0% (black) 1,0% (mir) | - |
| Small | 24x23x3.9 | 1, 04 | 6,0% | 3,3 | 0,426 | 0,53 | 0,74 | 10,5% | 176,0% |
| dil | | 1,04 (black) 6,32 (mir) | | 1,5 (black) 3,6 (mir) | 0,414 (black) 0,432 (mir) | 0,52 (black) 0,51 (mir) | 0,28 (black) 0, 80 (mir) | 9,3% (black) 1,9% (mir) | 155,1% (black) 31,9% (mir) |
| Small conc | 32x23x3.8 | 1,17 1,17 (black) 8, 01 (mir) | 9,0% | 5, 54,07 (black)6, 1 (mir) | 0,462 0,454 (black) | 0,54 0,55 (black) 0,55 (mir) | 1,40% 1,05% (black) 1,62% | 16,7% 12,0 (black) 2,6% (mir) | 184,6% 126,5% (black) 28,8% (mir) |
| Long dil | 87x16x3.9 | 1,33 1,33 (black) 21, 9 (mir) | 7,5 % | 4,17 4,7 (mir) | 0,4193 | 0,52 0,52 (mir) | 0,95% 0,87% (black) 1,15% (mir) | 10,8% 9,2% (black) 0,8% (mir) | 144,1% 122,8% (black) 8,8%(mir) |

For calculating the short circuit current density, indicated with $J_{sc}$, the area of the concentrator physically in contact with the cell surface, equal to 0,48 cm$^2$, has been considered. We note that the power conversion efficiency (as mentioned, also Power Conversion Efficiency - PCE) is strongly enhanced by the presence of silicon nanocrystals SiNCs with respect to the polymer plate without any luminophore, ranging from 40% to 330% of the growth factor. This improvement is due to an increase in the short circuit current ($J_{sc}$), which is directly proportional to the flow of incident photons.

Since the open circuit voltage ($V_{oc}$) and the filling factor (FF) are only slightly dependent on the flow of photons, these last parameters have not been particularly influenced by the presence of silicon nanocrystals SiNCs. It is also possible to note that no particular increase in efficiency has been observed by mirroring the surface of the free edges (i.e. addition of reflecting surfaces or mirrors on the edges).

To obtain information on the concentration efficiency of the polymer sheet 2, the optical yield from the photovoltaic measurements was calculated with the following formula:

$$\eta_{opt} = \frac{J_{LSC}}{J_{SC} \times G}$$

Where $J_{LSC}$ is the current density of the photovoltaic cell 3 coupled with the polymer sheet 2, $J_{SC}$ is the current density of the photovoltaic cell 3 under a direct illumination and G is the dimensional factor described above. Likewise the PCE, optical efficiency is also greatly improved by the presence of silicon nanocrystals SiNCs.

For measurement with reflecting surfaces, $\eta_{opt}$ moves from 0,1% for the sample without nanocrystals, to 2,6%, in case of a sample with high concentration of silicon nanocrystals SiNCs.

The same behavior can be observed for the measurements with the reflecting surfaces on the edges 21, but the absolute values are considerably increased up to 16,7%. This difference can be attributed to the lowest G factor, calculated for this measurement configuration, which is probably overestimated.

In fact, this measurement configuration takes into account that the light which strikes the edges 21 of the polymer sheet 2 not coupled with the photovoltaic cell 3 is entirely dispersed, although in a more realistic case the diffusion from such edges can not be neglected. This radiation probably contributes to the overall efficiency of the polymer sheet 2. For this reason, the measurements carried out in the configuration with the black tape show a lower and more accurate optical efficiency.

On the contrary, it is also expected that the configuration with the reflecting surfaces underestimate the real efficiency, since it involves more reflection events inside the polymer sheet 2, increasing the losses and reducing the overall optical efficiency.

This is also the reason for explaining why the Power Conversion Efficiency (PCE) measured with configurations with and without reflective surfaces is comparable.

The optical efficiency is dependent on the absorbed light fraction, so the optical quantum efficiency can be calculated just by dividing the optical efficiency by the light fraction absorbed by the polymer sheet 2:

$$\eta_{opt} = \frac{J_{LSC}}{J_{SC} \times G \times \eta_{abs}}$$

Referring to figure 8, the dependence of the efficiency of the photovoltaic cell 3 and the optical efficiency with respect to the G factor for the sample with surfaces reflecting at the edges 21 with respect to the high concentration sample is shown, to get an information on the intrinsic limit of the optical efficiency in a sample with the dimensions of a real window.

It is observed that the efficiency of the photovoltaic cell 3 increases with a linear trend with the increase in the length of the side of the polymer sheet 2, in line with the increasing surface of the irradiated side. On the contrary, optical efficiency was observed to be exponentially decreasing with the increasing G-factor.

Interestingly, optical efficiency seems to stabilize when the G factor is greater than 15 to a value close to 0,8%, indicating that optical losses appear to be constant after a short distance due to lack of reabsorption.

Finally, the spectral response of the polymer sheet 2 was also measured, comparing it with that of the photovoltaic cell 2.

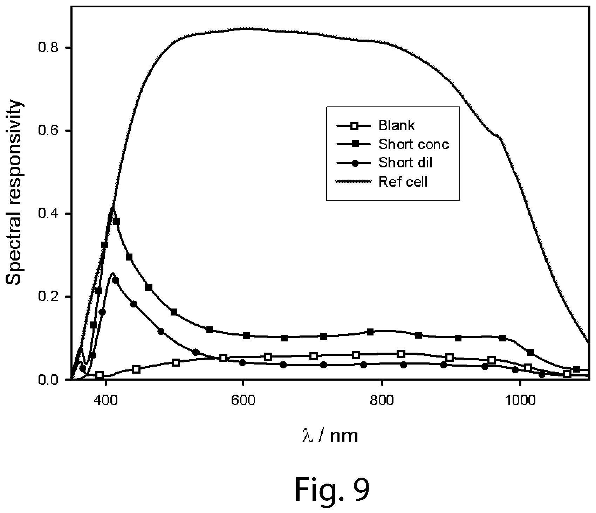

Comparing the shape of the spectral response between a polymer sheet 2 which incorporates silicon nanocrystals SiNCs and that of the free sample, a new band is clearly visible in the blue region (see figure 9), reproducing the absorption band typical of silicon nanocrystals SiNCs.

In general, the operation of the solar energy conversion device 1 described above is as follows.

When light L, or radiation in general, which in this case is sunlight, incides the surface 21 of said polymer sheet 2, the ultraviolet component and a small percentage of visible light are absorbed by silicon nanocrystals (SiNCs), which are then able to re-emit light C in the red or in the near infrared (NIR) inside the polymer, which said polymer sheet 2 is made of.

By means of a waveguide effect, the emitted light C is conveyed towards the edges 22 of the polymer sheet 2, where it is converted into electrical energy by said solar cell 3, thus generating a usable electric current.

An advantage of the solar energy conversion device according to the present invention is the low toxicity of the material used and the ease of production of the photoactive material.

A further advantage according to the present invention is given by the high availability of silicon in the terrestrial crust.

It is also advantage of the present invention the possibility of functionalizing the semiconductor with organic binders to modify the optical, solubility, dispersion, and stability properties.

## Claims

1. Energy conversion device (1), particularly electromagnetic energy, such as sunlight and the like, comprising a transparent polymer sheet (2) having an edge (22) and a surface (21), on which said electromagnetic radiation (L) can impact, and
a photovoltaic cell (3) mechanically coupled with said edge of said polymer sheet (2), capable of transforming in an electrical current the radiation incident on it,
wherein said polymer sheet (2) comprises a polymeric matrix having embedded silicon nanostructures, functionalized with organic binders, said polymeric sheet (2) being then luminescent with respect to a portion of said electromagnetic radiation (L), so as to convey the same, through a waveguide, towards said photovoltaic cell (3),
said silicon nanostructures comprise silicon nanocrystals (SiNCs) and/or silicon nanowires and/or porous silicon, and **characterised in that** said polymeric matrix is based on a functional monomer, such as lauryl methacrylate, methyl methacrylate, styrene or derivatives of the same; and a linking agent such as ethylene glycol dimethacrylate, propylene glycol methacrylate or derivatives.

**2.** Device (1) according to claim 1, **characterized in that** said silicon nanostructures have a size smaller than, or equal to 100 nm.

**3.** Device (1) according to any one of the preceding claims, **characterized in that** the organic binders are selected from the group consisting of: linear alkyl or alkenyl binders, such as 1-dodecene, 1-decene, 1-hexadecene, 1-undecene, 1-octadecene; alkyl or alkenyl silicon-containing binders, such as chloro(dimethyl) vinylsilane, chloro(dimethyl) allylxylane, chloro(dipropyl) vinylsilane, chloro(dibenzyl) vinylsilane and derivatives of the same; ethylene glycols binders; aromatic binders, such as styrene, phenylacetylene, anthracene, naphthalene, 2-aminopyridine, quinine sulphate and derivatives of the same;
said binder providing specific solubility, dispersion, stability or ultraviolet light absorption properties, said binders mixtures can be used to provide simultaneously different properties.

**4.** Device (1) according to claim 1, **characterized in that** the ratio between the functional monomer and the linking agent described above is comprised between 5% and 30%.

**5.** Method for realizing a polymeric matrix, for the manufacture of a transparent polymer sheet (2) as recited in claim 1, having silicon nanostructures, comprising the following steps:

(a) synthesize said silicon nanostructures by a thermal annealing step in a reducing atmosphere of polysiloxanes, for obtaining a powder;
(b) treating said powder obtained in said synthesizing step (a) with hydrofluoric acid to remove the silicon oxide matrix and release said hydride terminated silicon nanostructures;
(c) functionalizing said silicon nanostructures by the reaction with an organic binder selected from the group consisting of chloro(dimethyl) vinylsilane, chloro(dimethyl) allylxylane, chloro(dipropyl) vinylsilane, chloro(dibenzyl) vinylsilane and derivatives of the same; ethylene glycols binders; aromatic binders, such as styrene, phenylacetylene, anthracene, naphthalene, 2-aminopyridine, quinine sulphate and derivatives of the same; and
(d) preparing said polymeric matrix, in which including said silicon nanostructures, within a polymer matrix by in-situ polymerization of the polymers of said matrix.

**6.** Method according to claim 5, **characterized in that** said functionalizing step (c) comprises the step of induced passivation by heating the silicon nanostructures in an inert atmosphere at temperatures greater than, or equal to 150 °C, with an organic binder.

**7.** Method according to any one of claims 5 or 6, **characterized in that** said functionalizing step (c) comprises the passivation step induced by the activation of the silicon nanostructure by reaction with a diazonium salt, such as for example, 4-decylbenzene diazonium tetrafluoroborate, 4-bromobenzene diazonium tetrafluoroborate, 2-nitro-4-decyl-benzene diazonium tetrafluoroborate and 2,6-bromo-decyl-benzene diazonium tetrafluoroborate or AIBN (2,2'-azobis (2-methylpropionitrile) and subsequent addition of the organic binder in solvents such as toluene, hexane, cyclohexane, dichloromethane, chloroform, tetrahydrofuran.

**8.** Method according to any one of claims 6 or 7, **characterized in that** in the passivation step it is used a solvent selected from the same organic ligand or a neutral solvent selected from dodecane, hexadecane, octadecane, mesitylene, dichlorobenzene, trichlorobenzene, toluene, hexane, cyclohexane, dichloromethane, chloroform, tetrahydrofuran.

**9.** Method according to any one of claims 5-8, **characterized in that** said in-situ polymerization step (d) is carried out by dispersing said silicon nanostructures in a mixture of functional monomer and linking agent with a thermal or photochemical initiator.

**10.** Method according to claim 9, **characterized in that** said mixture of lauryl methacrylate/ethylene glycol dimethacrylate comprises lauryl methacrylate from 60% to 90% by weight and ethylene glycol dimethacrylate from 10 to 40% by weight.

**11.** Method according to any one of claims 9 or 10, **characterized in that** said thermal initiator is a solution of lauryl peroxide, AIBN (2,2'-azobis (2-methylpropionitrile, ABCN 1,1'-azobis (cyclohexanecarbonitrile) or benzoyl peroxide, in a concentration ranging from 0,05% to 1% by weight with respect to the solution.

**12.** Method according to any one of claims 9 - 11, **characterized in that** said photochemical initiator is a solution of diphenyl (2, 4, 6-trimethylbenzoyl) phosphine oxide or Irgacure 651 in a concentration ranging from 0,05% to 1% by weight with respect to the solution.

13. Method according to any one of claims 5 - 12, **characterized in that** it comprises a thermal activation phase, at a temperature between 40 °C and 100 °C, and/or photochemistry activation phase, with irradiation in the range between 300 and 450 nm, of said polymerization of said mixture in an appropriate mold until reaching the solid state.

14. Method according to any one of claims 5 - 13, **characterized in that** it comprises the step of removing the device from the mold and the following polishing of the surface by mechanical means.

15. Method according to any one of claims 5 - 14, **characterized in that** said nanostructures comprise silicon nanocrystals and/or nanowires of silicon and/or porous silicon.

**Patentansprüche**

1. Vorrichtung (1) zur Umwandlung von Energie, insbesondere von elektromagnetischer Energie, wie Sonnenlicht und dergleichen, umfassend
   eine transparente Polymerfolie (2), die einen Rand (22) und eine Oberfläche (21) aufweist, auf die die elektromagnetische Strahlung (L) auftreffen kann, und
   eine Photovoltaikzelle (3), die mechanisch mit dem Rand der Polymerfolie (2) gekoppelt und in der Lage ist, die auf sie auftreffende Strahlung in einen elektrischen Strom umzuwandeln,
   wobei die Polymerfolie (2) eine Polymermatrix umfasst, die eingebettete Silizium-Nanostrukturen aufweist, die mit organischen Bindemitteln funktionalisiert sind, wobei die Polymerfolie (2) dann in Bezug auf einen Teil der elektromagnetischen Strahlung (L) lumineszierend ist, um dieselben durch einen Wellenleiter in Richtung der Photovoltaikzelle (3) zu leiten,
   die Silizium-Nanostrukturen Silizium-Nanokristalle (SiNCs) und/oder Silizium-Nanodrähte und/oder poröses Silizium umfassen und
   **dadurch gekennzeichnet, dass** die Polymermatrix auf einem funktionellen Monomer wie Laurylmethacrylat, Methylmethacrylat, Styrol oder Derivaten derselben; und einem Bindemittel wie Ethylenglykoldimethacrylat, Propylenglykolmethacrylat oder Derivaten davon basiert.

2. Vorrichtung (1) nach Anspruch 1, **dadurch gekennzeichnet, dass** die Silizium-Nanostrukturen eine Größe von kleiner als oder gleich 100 nm aufweisen.

3. Vorrichtung (1) nach einem der vorstehenden Ansprüche, **dadurch gekennzeichnet, dass** die organischen Bindemittel ausgewählt sind aus der Gruppe bestehend aus: linearen Alkyl- oder Alkenylbindemitteln wie 1-Dodecen, 1-Decen, 1-Hexadecen, 1-Undecen, 1-Octadecen; alkyl- oder alkenylsilikonhaltigen Bindemitteln wie Chlor(dimethyl)vinylsilan, Chlor(dimethyl)allylxylan, Chlor(dipropyl)vinylsilan, Chlor(dibenzyl)vinylsilan und Derivaten derselben; Ethylenglykolen als Bindemittel; aromatischen Bindemitteln wie Styrol, Phenylacetylen, Anthracen, Naphthalin, 2-Aminopyridin, Chininsulfat und Derivaten derselben;
   wobei das Bindemittel spezifische Löslichkeits-, Dispersions-, Stabilitäts- oder Ultraviolettlichtabsorptionseigenschaften bereitstellt, wobei die Bindemittelmischungen verwendet werden können, um gleichzeitig verschiedene Eigenschaften bereitzustellen.

4. Vorrichtung (1) nach Anspruch 1, **dadurch gekennzeichnet, dass** das Verhältnis zwischen dem funktionellen Monomer und dem oben beschriebenen Vernetzungsmittel zwischen 5 % und 30 % liegt.

5. Verfahren zur Realisierung einer Polymermatrix zur Herstellung einer transparenten Polymerfolie (2) nach Anspruch 1, die Silizium-Nanostrukturen aufweist, umfassend die folgenden Schritte:

   (a) Synthetisieren der Silizium-Nanostrukturen durch einen thermischen Glühschritt in einer reduzierenden Atmosphäre von Polysiloxanen, um ein Pulver zu erhalten;
   (b) Behandeln des in dem Syntheseschritt (a) erhaltenen Pulvers mit Flusssäure, um die Siliziumoxidmatrix zu entfernen und die Siliziumnanostrukturen mit Hydrid-Endgruppen freizusetzen;
   (c) Funktionalisieren der Silizium-Nanostrukturen durch die Umsetzung mit einem organischen Bindemittel, ausgewählt aus der Gruppe bestehend aus Chlor(dimethyl)vinylsilan, Chlor(dimethyl)allylxylan, Chlor(dipropyl)vinylsilan, Chlor(dibenzyl)vinylsilan und Derivaten derselben; Ethylenglykolen als Bindemittel; aromatischen Bindemitteln wie Styrol, Phenylacetylen, Anthracen, Naphthalin, 2-Aminopyridin, Chininsulfat und Derivaten derselben; und

(d) Erstellen der Polymermatrix, in der die Silizium-Nanostrukturen enthalten sind, innerhalb einer Polymermatrix durch In-situ-Polymerisation der Polymere der Matrix.

**6.** Verfahren nach Anspruch 5, **dadurch gekennzeichnet, dass** der Funktionalisierungsschritt (c) den Schritt der induzierten Passivierung durch Erhitzen der Silizium-Nanostrukturen in einer inerten Atmosphäre bei Temperaturen größer als oder gleich 150 °C mit einem organischen Bindemittel umfasst.

**7.** Verfahren nach einem der Ansprüche 5 oder 6, **dadurch gekennzeichnet, dass** der Funktionalisierungsschritt (c) den Passivierungsschritt umfasst, der durch die Aktivierung der Siliciumnanostruktur durch Umsetzung mit einem Diazoniumsalz, wie zum Beispiel 4-Decylbenzoldiazoniumtetrafluorborat, 4-Brombenzoldiazoniumtetrafluorborat, 2-Nitro-4-decyl-benzoldiazoniumtetrafluoroborat und 2,6-Brom-decylbenzoldiazoniumtetrafluoroborat oder AIBN (2,2'-Azobis(2-methylpropionitril) und anschließender Zugabe des organischen Bindemittels in Lösungsmitteln wie Toluol, Hexan, Cyclohexan, Dichlormethan, Chloroform, Tetrahydrofuran induziert wird.

**8.** Verfahren nach einem der Ansprüche 6 oder 7, **dadurch gekennzeichnet, dass** in dem Passivierungsschritt ein Lösungsmittel verwendet wird, das aus dem gleichen organischen Liganden oder einem neutralen Lösungsmittel ausgewählt ist, das aus Dodekan, Hexadekan, Oktadekan, Mesitylen, Dichlorbenzol, Trichlorbenzol, Toluol, Hexan, Cyclohexan, Dichlormethan, Chloroform, Tetrahydrofuran ausgewählt ist.

**9.** Verfahren nach einem der Ansprüche 5-8, **dadurch gekennzeichnet, dass** der In-situ-Polymerisationsschritt (d) durch Dispergieren der Silicium-Nanostrukturen in einem Gemisch aus funktionellem Monomer und Vernetzungsmittel mit einem thermischen oder photochemischen Initiator durchgeführt wird.

**10.** Verfahren nach Anspruch 9, **dadurch gekennzeichnet, dass** das Gemisch aus Laurylmethacrylat/Ethylenglykoldimethacrylat 60 bis 90 Gew.-% Laurylmethacrylat und 10 bis 40 Gew.-% Ethylenglykoldimethacrylat umfasst.

**11.** Verfahren nach einem der Ansprüche 9 oder 10, **dadurch gekennzeichnet, dass** der thermische Initiator eine Lösung von Laurylperoxid, AIBN (2,2'-Azobis(2-methylpropionitril, ABCN 1,1'-Azobis(cyclohexancarbonitril) oder Benzoylperoxid in einer Konzentration im Bereich von 0,05 % bis 1 Gew.-%, bezogen auf die Lösung, ist.

**12.** Verfahren nach einem der Ansprüche 9 bis 11, **dadurch gekennzeichnet, dass** der photochemische Initiator eine Lösung von Diphenyl-(2, 4, 6-trimethylbenzoyl)-phosphinoxid oder Irgacure 651 in einer Konzentration von 0,05 bis 1 Gew.-%, bezogen auf die Lösung, ist.

**13.** Verfahren nach einem der Ansprüche 5 bis 12, **dadurch gekennzeichnet, dass** es eine thermische Aktivierungsphase bei einer Temperatur zwischen 40 °C und 100 °C und/oder eine photochemische Aktivierungsphase mit Bestrahlung im Bereich zwischen 300 und 450 nm der Polymerisation des Gemischs in einer geeigneten Form bis zum Erreichen des festen Zustands umfasst.

**14.** Verfahren nach einem der Ansprüche 5 bis 13, **dadurch gekennzeichnet, dass** es den Schritt der Entnahme der Vorrichtung aus der Form und das anschließende Polieren der Oberfläche mit mechanischen Mitteln umfasst.

**15.** Verfahren nach einem der Ansprüche 5 bis 14, **dadurch gekennzeichnet, dass** die Nanostrukturen Silizium-Nanokristalle und/oder Nanodrähte aus Silizium und/oder porösem Silizium umfassen.

**Revendications**

**1.** Dispositif de conversion d'énergie (1), en particulier d'énergie électromagnétique, telle que de la lumière solaire et analogue, comprenant

une feuille de polymère transparente (2) présentant un bord (22) et une surface (21), sur laquelle ledit rayonnement électromagnétique (L) peut avoir un impact, et

une cellule photovoltaïque (3) couplée mécaniquement audit bord de ladite feuille de polymère (2), capable de transformer en un courant électrique le rayonnement incident sur elle,

dans lequel ladite feuille de polymère (2) comprend une matrice polymère présentant des nanostructures de silicium intégrées, fonctionnalisées avec des liants organiques, ladite feuille de polymère (2) étant alors luminescente par rapport à une partie dudit rayonnement électromagnétique (L), de sorte à transporter celui-ci, au moyen d'un guide d'ondes, vers ladite cellule photovoltaïque (3), lesdites nanostructures de silicium comprennent des nanocristaux de silicium (SiNC) et/ou des nanofils de silicium et/ou du silicium poreux, et **caractérisé en ce que** ladite matrice polymère est basée sur un monomère fonctionnel, tel que du méthacrylate de lauryle, du méthacrylate de méthyle, du styrène ou des dérivés de ceux-ci, et un agent de liaison tel que du diméthacrylate d'éthylène glycol, du méthacrylate de propylène glycol ou des dérivés.

2. Dispositif (1) selon la revendication 1, **caractérisé en ce que** lesdites nanostructures de silicium présentent une taille inférieure ou égale à 100 nm.

3. Dispositif (1) selon l'une quelconque des revendications précédentes, **caractérisé en ce que** les liants organiques sont sélectionnés dans le groupe consistant en : liants d'alkyle ou d'alcényle linéaires, tels que 1-dodécène, 1-décène, 1-hexadécène, 1-undécène, 1-octadécène ; liants d'alkyle ou d'alcényle contenant du silicium, tels que chloro(diméthyl)vinylsilane, chloro(diméthyl)allylxylane, chloro(dipropyl)vinylsilane, chloro(dibenzyl)vinylsilane et dérivés de ceux-ci ; liants d'éthylène glycols ; liants aromatiques, tels que styrène, phénylacétylène, anthracène, naphtalène, 2-aminopyridine, sulfate de quinine et dérivés de ceux-ci ;
ledit liant conférant des propriétés de solubilité, de dispersion, de stabilité ou d'absorption de lumière ultraviolette spécifiques, lesdits mélanges de liants peuvent être utilisés pour conférer simultanément des propriétés différentes.

4. Dispositif (1) selon la revendication 1, **caractérisé en ce que** le rapport entre le monomère fonctionnel et l'agent de liaison décrits ci-dessus est compris entre 5 % et 30%.

5. Procédé pour réaliser une matrice polymère, pour la fabrication d'une feuille de polymère transparente (2) telle que mentionnée dans la revendication 1, présentant des nanostructures de silicium, comprenant les étapes suivantes consistant à :

   (a) synthétiser lesdites nanostructures de silicium au moyen d'une étape de recuit thermique dans une atmosphère réductrice de polysiloxanes, pour obtenir une poudre ;
   (b) traiter ladite poudre obtenue à ladite étape (a) de synthèse avec de l'acide hydrofluorique pour éliminer la matrice d'oxyde de silicium et libérer lesdites nanostructures de silicium à terminaison hydrure ;
   (c) fonctionnaliser lesdites nanostructures de silicium par la réaction avec un liant organique sélectionné dans le groupe consistant en chloro(diméthyl)vinylsilane, chloro(diméthyl)allylxylane, chloro(dipropyl)vinylsilane, chloro(dibenzyl)vinylsilane et dérivés de ceux-ci ; des liants d'éthylène glycols ; des liants aromatiques, tels que styrène, phénylacétylène, anthracène, naphtalène, 2-aminopyridine, sulfate de quinine et dérivés de ceux-ci ; et
   (d) préparer ladite matrice polymère, dans laquelle sont incluses lesdites nanostructures de silicium, dans une matrice polymère par polymérisation in situ des polymères de ladite matrice.

6. Procédé selon la revendication 5, **caractérisé en ce que** ladite étape de fonctionnalisation (c) comprend l'étape de passivation induite par chauffage des nanostructures de silicium dans une atmosphère inerte à des températures supérieures ou égales à 150 °C avec un liant organique.

7. Procédé selon l'une quelconque des revendications 5 ou 6, **caractérisé en ce que** ladite étape (c) de fonctionnalisation comprend l'étape de passivation induite par l'activation de la nanostructure de silicium par réaction avec un sel de diazonium, tel que, par exemple, tétrafluoroborate de 4-décylbenzène diazonium, tétrafluoroborate de 4-bromobenzène diazonium, tétrafluoroborate de 2-nitro-4-décyl-benzène diazonium et tétrafluoroborate de 2,6-bromo-décyl-benzène diazonium ou AIBN (2,2'-azobis (2-méthylpropionitrile) et un ajout consécutif du liant organique dans des solvants, tels que toluène, hexane, cyclohexane, dichlorométhane, chloroforme, tétrahydrofurane.

8. Procédé selon l'une quelconque des revendications 6 ou 7, **caractérisé en ce que**, à l'étape de passivation, on utilise un solvant sélectionné parmi le même ligand organique ou un solvant neutre sélectionné parmi dodécane, hexadécane, octadécane, mésitylène, dichlorobenzène, trichlorobenzène, toluène, hexane, cyclohexane, dicholorométhane, chloroforme, tétrahydrofurane.

9. Procédé selon l'une quelconque des revendications 5-8, **caractérisé en ce que** ladite étape (d) de polymérisation in situ est réalisée par dispersion desdites nanostructures de silicium dans un mélange de monomère fonctionnel et d'agent de liaison avec un initiateur thermique ou photochimique.

**10.** Procédé selon la revendication 9, **caractérisé en ce que** ledit mélange de méthacrylate de lauryle/diméthacrylate d'éthylène glycol comprend du méthacrylate de lauryle de 60 % à 90 % en poids et du diméthacrylate d'éthylène glycol de 10 à 40 % en poids.

**11.** Procédé selon l'une quelconque des revendications 9 ou 10, **caractérisé en ce que** ledit initiateur thermique est une solution de peroxyde de lauryle, AIBN (2,2'-azobis (2-méthylpropionitrile), ABCN 1,1'-azobis (cyclohexanecarbonitrile) ou peroxyde de benzoyle, dans une concentration allant de 0,05 % à 1 % en poids par rapport à la solution.

**12.** Procédé selon l'une quelconque des revendications 9-11, **caractérisé en ce que** ledit initiateur photochimique est une solution d'oxyde de diphényl(2,4,6-triméthylbenzoyl)phosphine ou d'Irgacure 651 dans une concentration allant de 0,05 % à 1 % en poids par rapport à la solution.

**13.** Procédé selon l'une quelconque des revendications 5-12, **caractérisé en ce qu'**il comprend une phase d'activation thermique, à une température entre 40 °C et 100 °C et/ou une phase d'activation photochimique, avec une irradiation dans la plage entre 300 et 450 nm, de ladite polymérisation dudit mélange dans un moule approprié jusqu'à atteindre l'état solide.

**14.** Procédé selon l'une quelconque des revendications 5-13, **caractérisé en ce qu'**il comprend l'étape d'enlèvement du dispositif du moule et le polissage ultérieur de la surface par des moyens mécaniques.

**15.** Procédé selon l'une quelconque des revendications 5-14, **caractérisé en ce que** lesdites nanostructures comprennent des nanocristaux de silicium et/ou des nanofils de silicium et/ou du silicium poreux.

Fig. 1

Fig. 2

| | Size | $\lambda_{em}$ | $\tau_{SiNC}$ | $\Phi_{PL}$ |
|---|---|---|---|---|
| SiNCs 1100°C | 3.2 nm | 760 nm | 80 µs | 0.27 |
| SiNCs 1200°C | 5.0 nm | 1000 nm | 150 µs | 0.45 |

Fig. 3

Fig. 4a

Fig. 4b

Fig. 5

Fig. 6

Fig. 7

Fig. 8

Fig. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010180932 A
- WO 2015002995 A1
- WO 2016060643 A
- WO 2016028855 A
- WO 2016028855 A1

**Non-patent literature cited in the description**

- **MEINARDI, F. ; MCDANIEL, H. ; CARULLI, F. ; CO-LOMBO, A. ; VELIZHANIN, K. A. ; MAKAROV, N. S. ; SIMONUTTI, R. ; KLIMOV, V. I. ; BROVELLI, S.** *Nat. Nanotechnol.,* 2015, vol. 10 (10), 878-885
- **COROPCEANU, I. ; BAWENDI, M.G.** *Nano Lett.,* 2014, vol. 14 (7), 4097-4101